(19) **Europäisches Patentamt / European Patent Office / Office européen des brevets**

(11) **EP 4 280 853 B1**

(12) **EUROPEAN PATENT SPECIFICATION**

(45) Date of publication and mention
of the grant of the patent:
**19.03.2025  Bulletin 2025/12**

(21) Application number: **23174108.3**

(22) Date of filing: **17.05.2023**

(51) International Patent Classification (IPC):
*H10N 30/00* (2023.01)   *H10N 30/30* (2023.01)
*H10N 30/80* (2023.01)   *H10N 30/853* (2023.01)

(52) Cooperative Patent Classification (CPC):
**H10N 30/80; H10N 30/302; H10N 30/708;
H10N 30/8536**

(54) **VIBRATION-TYPE ACTUATOR, ELECTRONIC DEVICE, AND OPTICAL DEVICE**

VIBRATIONSAKTUATOR, ELEKTRONISCHE VORRICHTUNG UND OPTISCHE VORRICHTUNG

ACTIONNEUR DE TYPE À VIBRATION, DISPOSITIF ÉLECTRONIQUE ET DISPOSITIF OPTIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **20.05.2022   JP 2022083064**

(43) Date of publication of application:
**22.11.2023   Bulletin 2023/47**

(73) Proprietor: **CANON KABUSHIKI KAISHA
Tokyo 146-8501 (JP)**

(72) Inventors:
• **UEBAYASHI, Akira
Tokyo, 146-8501 (JP)**
• **WATANABE, Takayuki
Tokyo, 146-8501 (JP)**
• **ODA, Yuki
Tokyo, 146-8501 (JP)**

(74) Representative: **Canon Europe Limited
European Intellectual Property Group
4 Roundwood Avenue
Stockley Park
Uxbridge UB11 1AF (GB)**

(56) References cited:
**EP-A1- 2 523 231     EP-A1- 3 579 258
EP-A1- 3 716 645**

**Description**

BACKGROUND OF THE INVENTION

Field of the Invention

The present invention relates to a vibration-type actuator, an electronic device including the vibration-type actuator, and an optical device including the vibration-type actuator.

Description of the Related Art

A vibration-type actuator includes a vibration body and a contact body. The vibration body includes an electric-mechanical energy conversion element, such as a piezoelectric element, and an elastic body. The contact body is pressed against and brought into contact with the vibration body. The vibration-type actuator is used as a vibration wave motor which relatively moves the contact body by using friction generated from driving power of vibration excited by the vibration body.

A piezoelectric zirconate titanate (PZT) material is generally used as a piezoelectric material for the piezoelectric element. However, use of a piezoelectric material with perovskite-type metallic oxide which does not contain lead (perovskite-type metallic oxide with a lead content less than 1000 ppm) has been proposed because negative effect of lead on the environment has been perceived as an issue.

Further, Japanese Patent Application Laid-Open No. 2018-107437 discusses a vibration wave motor using a vibration body including a rectangular-shape vibration plate and a piezoelectric element made of a non-leaded piezoelectric material. A structure of the vibration wave motor regarded as one type of the vibration-type actuator and an outline of a drive principle thereof will be described. The vibration wave motor includes the vibration body and a contact body pressed against and brought into contact with the vibration body by a pressure member. At this time, it is desirable that the pressure member having high rigidity is brought into contact with the vibration body in order to uniformly apply pressure thereto. However, bringing a member having high rigidity into contact with the vibration body hinders the vibration of the vibration body, so that the drive characteristic of the motor is degraded.

There has been known a structure in which a member functioning as a vibration attenuation member that does not hinder the vibration is arranged between the pressure member and the vibration body.

For example, according to Japanese Patent Application Laid-Open No. 3-289371, sponge, foamed polystyrene, and wool felt are exemplified, and the wool felt among them especially excels as a supporting body of the vibration body. In addition, a material that does not hinder vibration is used for the supporting body of the vibration body discussed in Japanese Patent Application Laid-Open No. 3-289371. Thus, the functions thereof are thought to be equivalent to that of the vibration attenuation member discussed in Japanese Patent Application Laid-Open No. 2018-107437. The patent document EP3716645 A1 relates to a piezoelectric speaker with a piezoelectric film; a pressure-sensitive adhesive layer for fixing the piezoelectric film to a support; and a porous body layer disposed between the piezoelectric film and the pressure-sensitive adhesive layer. The patent document EP2523231 A1 is directed to an ultrasonic diagnostic equipment where a composite piezoelectric element contains air bubbles mixed in the organic polymer material. Document EP3579258 A1 describes an energy conversion film made of a charged resin film prepared by injecting a charge to a resin film at least containing a thermoplastic resin and a metal soap, and optional skin layers respectively on both upper and lower surfaces of the resin film.

However, through the study conducted by the inventor, the following issues were found. A drop in driving efficiency was observed under low temperatures when felt was used as a vibration attenuation member of a vibration-type actuator including a piezoelectric element including a non-leaded piezoelectric material. In particular, in a low temperature region where the temperature becomes less than or equal to a glass-transition temperature of felt, specifically, -20°C or less, the felt is hardened, power consumption (input power at constant speed, e.g., 100 mm/s) increases when the actuator is driven at a low temperature, and the driving efficiency is lowered significantly.

The present invention is directed to a vibration-type actuator that reduces or prevents increase in power consumption when being driven at a low temperature, even with the use of a non-leaded piezoelectric material. According to the present invention, it is possible to realize a stable operation in an operating temperature range (e.g., -30°C to 60°C). The present invention is also directed to an electronic device and an optical device using the vibration-type actuator.

SUMMARY OF THE INVENTION

According to a first aspect of the present invention, there is provided a vibration-type actuator as specified in claims 1 to 14. According to a second aspect of the present invention, there is provided an electronic device as specified in claim 15. According to a third aspect of the present invention, there is provided an optical device as specified in claim 16.

Further features of the present invention will become apparent from the following description of embodiments with reference to the attached drawings.

BRIEF DESCRIPTION OF THE DRAWINGS

Figs. 1A to 1F are diagrams illustrating schematic structures of a vibration-type actuator including a ring shape piezoelectric material or a rectangular shape piezoelectric material according to the present invention, where Figs. 1A and 1D are side views, Figs. 1B and 1E are perspective views, and Fig. 1C and 1F are rear views.

Figs. 2A and 2B are diagrams illustrating two modes, specifically, a mode A (Fig. 2A) and a mode B (Fig. 2B), of vibration generated by a vibration body of the present invention including a rectangular shape piezoelectric material.

Fig. 3 is a schematic diagram illustrating a cross-sectional view of a foamed member according to the present invention.

Figs. 4A and 4B are schematic diagrams illustrating side views of foamed members according to the present invention.

Fig. 5 is a diagram illustrating a schematic structure of an optical device according to the present invention.

Fig. 6 is a graph illustrating a temperature dependency of relative permittivity of a piezoelectric material according to an embodiment of the present invention.

Fig. 7 is a graph illustrating a drive characteristic of a vibration-type actuator according to an embodiment of the present invention.

DESCRIPTION OF THE EMBODIMENTS

Hereinafter, embodiments embodying the present invention will be described. Each of the embodiments of the present invention described below can be implemented solely or as a combination of a plurality of the embodiments or features thereof where necessary or where the combination of elements or features from individual embodiments in a single embodiment is beneficial.

A vibration-type actuator according to the present invention includes a vibration body including an electric-mechanical energy conversion element with a lead content of 1000 ppm or less and an elastic body having a plate portion and protrusions protruding in a direction intersecting with a main face of the plate portion. The vibration-type actuator further includes a contact body that is brought into contact with the protrusions, and the vibration body and the contact body relatively move with the vibration generated by the vibration body. The vibration-type actuator further includes a pressure member for pressing the vibration body against the contact body and a foamed member arranged between the pressure member and the vibration body. The foamed member contains, as a main skeleton, a siloxane bond including silicon and oxygen, and an average equivalent circle diameter of bubbles contained in the foamed member is greater than 120 $\mu$m.

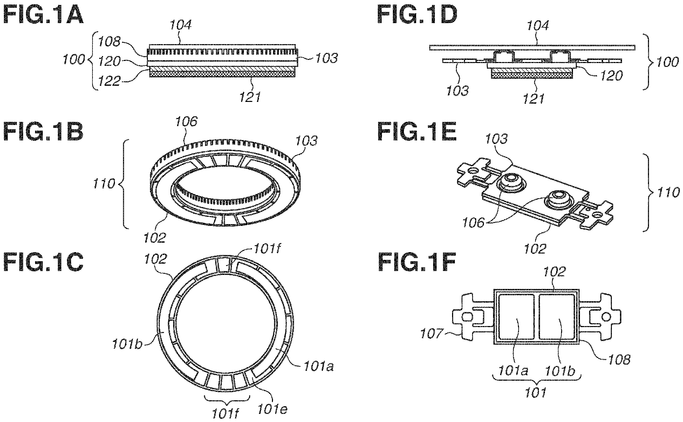

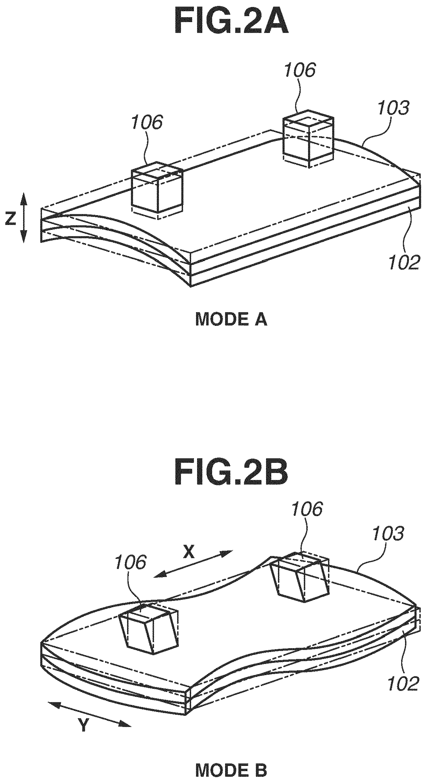

Figs. 1A to 1F and Figs. 2A and 2B illustrate schematic structures of vibration-type actuators 100 according to the present invention. The vibration-type actuator 100 with a vibration body 110 having a ring-shape plate portion is illustrated in Figs. 1A to 1F. The vibration-type actuator 100 with a vibration body 110 having a rectangular-shape plate portion is illustrated in Figs. 2A and 2B. The respective vibration-type actuator 100 according to the present invention includes an electric-mechanical energy conversion element 120 including an electrode 101 and a piezoelectric material 102. The vibration-type actuator 100 further includes an elastic body 103 having a plate portion 108 and protrusions 106 protruding, in an out-of-plane manner, in a direction intersecting with a main face of the plate portion 108, and these constituent elements are arranged in this order to form the vibration body 110. The vibration-type actuator 100 further includes a contact body 104 which is brought into contact with the protrusions 106. The vibration-type actuator 100 yet further includes a pressure member 121 for causing the vibration body 110 to be pressed against and brought into contact with the contact body 104 and a foamed member 122 arranged between the vibration body 110 and the pressure member 121.

Any member that is movable relative to the vibration body 110 is useable as the contact body 104, and the contact body 104 may directly be brought into contact with the vibration body 110, or may indirectly be brought into contact therewith via another member. A face of the electric-mechanical energy conversion element 120 is pressed by the pressure member 121 via the foamed member 122.

<Piezoelectric Material>

While any shape of the piezoelectric material 102 is applicable, it is desirable that the piezoelectric material be formed into a ring shape for the ring-shaped plate portion and be formed into a rectangular shape for the rectangular-shaped plate portion.

While a form of the piezoelectric material 102 is not limited, a piezoelectric material without having a crystal orientation (sintered body), a crystal-oriented ceramic, and a piezoelectric single crystal may be used. A shape of the piezoelectric material is not limited. For example, in order to form a stacked body of an electrode and a piezoelectric material, a layered piezoelectric material or a single-plate piezoelectric material may be employed. A single-plate piezoelectric material is advantageous in terms of cost. In order to drive the vibration-type actuator 100, the piezoelectric material is polarized. When a frequency of an alternating electric field applied to the polarized piezoelectric material approximates to a resonant frequency of the piezoelectric material, the piezoelectric material is greatly vibrated due to the resonance phenomenon.

<Electrodes>

In a case where a ring-shape piezoelectric material is used, an electrode 101 divided in a circumferential direction is provided on the piezoelectric material and a ring-shape piezoelectric element is formed. The electrode 101 includes driving phase electrodes 101e and non-driving phase electrodes 101f. A length in the circumferential direction of a driving phase electrode 101e is one-half of a wavelength $\lambda$ of an oscillating wave that occurs in the circumferential direction of the ring-shape piezoelectric element when alternating voltage is applied to the driving phase electrode 101e. A length in the circumferential direction of a non-driving phase electrode (i.e., a ground electrode or a monitoring electrode) 101f is one-fourth of the wavelength $\lambda$. The numbers of the driving phase electrodes 101e and the non-driving phase electrodes 101f are changed depending on the number of traveling waves for exciting the ring-shape piezoelectric material.

A piezoelectric material corresponding to each of the driving phase electrodes 101e is polarized with voltage having a polarity different from a polarity of the adjacent regions.

The driving phase electrodes 101e are partitioned by the odd number of non-driving phase electrodes 101f. After the polarization processing is performed, a first electrode 101a and a second electrode 101b are arranged to short-circuit the two groups of driving phase electrodes 101e partitioned by the non-driving phase electrodes 101f. The first electrode 101a and the second electrode 101b are used for driving the vibration-type actuator 100 using the ring-shape piezoelectric material.

A rectangular-shape electrode 101 is arranged in a case where a rectangular-shaped piezoelectric material is used. The electrode 101 includes a first electrode 101a and a second electrode 101b. The first electrode 101a and the second electrode 101b are used for performing the polarization processing on the rectangular-shape piezoelectric material and also used for driving the vibration-type actuator 100 using the rectangular shape piezoelectric material.

The electrode 101 is made of a metallic film having a thickness of about 0.3 to 10 $\mu$m. An electrode made of silver, gold, of platinum is used in general, although a material thereof is not limited specifically. A manufacturing method of the electrode 101 is not limited, and can be formed by the methods, such as screen printing, sputtering, and vacuum vapor deposition. In order to manufacture the electric-mechanical energy conversion element 120 with a lead content of 1000 ppm or less, a paste and/or a target with a lead content of less than 1000 ppm are/is to be used when the electrode 101 is formed.

<Elastic Body>

In view of the properties as an elastic body and workability thereof, it is desirable that the elastic body 103 be made of a metal. Examples of the metals that is useable for the elastic body 103 include aluminum, brass, and stainless steel. From among various types of stainless steel, martensite stainless steel is desirable, and SUS420J2 is the most desirable. The elastic body 103 includes the protrusions 106 which is brought into contact with the contact body 104. In order to further improve the abrasion resistance of the protrusions 106, the elastic body 103 is subjected to quenching, plating, and/or nitriding.

<Foamed Member>

As illustrated in Fig. 1A, the foamed member 122 is arranged on the face of the electric-mechanical energy conversion element 120 opposite to the other face on which the elastic body 103 is arranged. The foamed member 122 uniformly presses the vibration body 110 against the contact body 104, and also functions as a vibration attenuation member. The foamed member 122 absorbs vibrations transmitted from an adjacent member to attenuate the vibrations, as the function of the vibration attenuation member. The foamed member 122 may be arranged separately as long as the drive characteristic is not lowered.

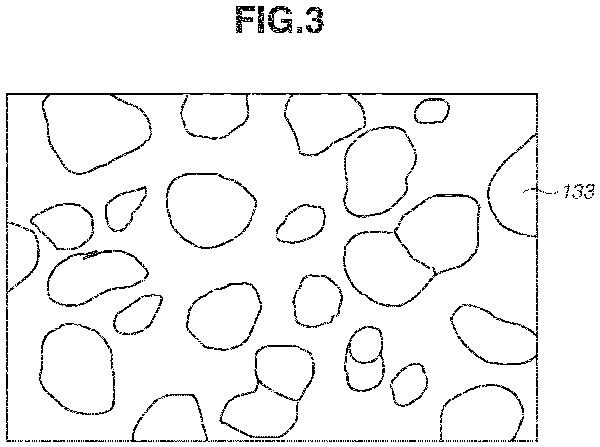

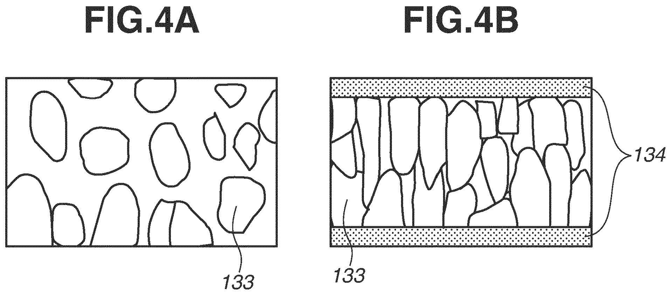

Fig. 3 is a diagram illustrating a horizontal sectional view (i.e., X-Y plane) of the foamed member 122 of the present invention. Figs. 4A and 4B are diagrams illustrating side views of the foamed members 122 of the present invention, in the vertical direction (i.e., Z direction). Fig. 4A is a side view of the foamed member 122 without a skin layer on a surface thereof, and Fig. 4B is a side view of the foamed member 122 having a skin layer on a surface thereof.

The foamed member 122 has a siloxane bond including silicon and oxygen as a main skeleton, and an average equivalent circle diameter of bubbles (e.g., bubbles 133 in Fig. 3 and Fig. 4A and 4B) contained in the foamed member 122

is greater than 120 μm. The foamed member 122 having a siloxane bond as a main skeleton increases mobility of molecules constituting the foamed member 122, thus making the glass-transition temperature of the foamed member 122 lower than the operating temperature, -30°C. Thus, even at low temperatures, the foamed member 122 maintains a physical property equivalent to that at room temperature.

It is desirable that an average equivalent circle diameter of bubbles in the foamed member 122 be greater than 120 μm. The presences of the bubbles enables the foamed member 122 to have a spring property, so that the foamed member 122 functions as a vibration attenuation member while uniformly pressing the vibration body 110 against the contact body 104. The average equivalent circle diameter of the bubbles is greater than 120 μm, so that the vibration-type actuator 100 using a non-leaded piezoelectric material maintains a vibration isolation property even at low temperatures. Thus, it is possible to improve the driving efficiency at low temperatures while maintaining the driving efficiency at room temperature.

It is desirable that the average equivalent circle diameter be calculated from a sectional shape of the foamed member 122. Making the average equivalent circle diameter of bubbles in a cross-section of the foamed member 122 greater than 120 μm enables the foamed member 122 to uniformly apply pressure to the vibration body 110 vibration body while maintaining a driving property of a motor, with the vibration of the vibration body 110 not being hindered.

The average equivalent circle diameter of the foamed member 122 can be obtained with a method such as image processing performed on a cross-sectional image obtained from observation of a cross-section. A cross-section is exposed by sectioning a sample, and sectional observation is conducted by using an optical microscope, a laser microscope, or the like. Alternatively, a tomographic image may be obtained nondestructively using an X-ray computed tomography (CT) scanner. Further, if it is possible to check a shape of the bubble, the surface that is brought into contact with the electric-mechanical energy conversion element 120 may be treated as a sectional shape. Either the image processing software optimized for the microscope or the one available in the market is useable. It is desirable that a large number of bubbles be observed when the average equivalent circle diameter is to be calculated because bubbles of various sizes are present. More specifically, it is desirable that the average equivalent circle diameter be calculated from fifty or more bubbles.

As illustrated in Fig. 4B, the foamed member 122 according to the present invention may have pillar-like bubbles, and a skin layer may be included on a surface thereof. As illustrated in Fig. 4B, in a case where the skin layer is present on the surface, it is desirable that a cross-section be exposed by sectioning the foamed member 122 because the bubbles cannot precisely be checked from the surface. The average equivalent circle diameter can be calculated by performing image processing on the acquired tomographic image.

It is desirable that the foamed member 122 have the siloxane bond as the main skeleton and have, as a major component, a polymer with a methyl group bonded to the main skeleton. Such a structure enables the foamed member 122 to maintain a vibration isolation property even at low temperatures. Further, a similar effect can also be produced with a foamed member having the methyl group partially replaced with a vinyl group or a phenyl group. Further, the above-described foamed member 122 may be a sponge which contains silicon rubber.

It is desirable that bubbles contained in the foamed member 122 be mainly closed-cell bubbles. A closed-cell bubble refers to a bubble which does not connect front and back faces of the foamed member 122. The closed-cell bubble does not easily transmit gas or liquid. Thus, in order to yield a spring property to the foamed member 122, it is desirable that the foamed member 122 contain the closed-cell bubbles. In contrast, open-cell bubbles are connected to each other, so that these bubbles have characteristics in that the bubbles easily let the air in and out, and easily collapse when pressure is applied thereto. Thus, the open-cell bubbles are inferior in term of a spring property, and not desirable because the foamed member 122 may fail to uniformly apply pressure to the vibration body 110, and may be degraded in a vibration attenuation function. It is desirable that the number of closed-cell bubbles be greater than the number of open-cell bubbles, more specifically, a percentage of the closed-cell bubbles accounting for the bubbles of the foamed member 122 be 50% or more. In this regard, the number thereof can be calculated from a tomographic image including 50 or more bubbles.

It is further desirable that the average equivalent circle diameter of the bubbles in the foamed member 122 be 200 μm or more. Making the average equivalent circle diameter of bubbles greater than or equal to 200 μm improves driving efficiency in a low temperature area, for the vibration-type actuator 100 using a piezoelectric material having a phase transition temperature of -10°C or lower to realize a stable operation in the operating temperature range (e.g., -30°C to 60°C). It is further desirable that the average equivalent circle diameter of the bubbles be greater than or equal to 300 μm.

It is desirable that the average equivalent circle diameter of the foamed member 122 be smaller than one-half of a thickness t of the foamed member 122. This configuration enables the foamed member 122 to function as a vibration attenuation member while uniformly applying pressure to the vibration body 110. It is further desirable that the foamed member 122 with average equivalent circle diameter smaller than one-third of the thickness t be employed.

<Contact Body>

From a viewpoint of rigidity, it is desirable that the contact body 104 be made of stainless steel. From among various types of stainless steel, martensite stainless steel is desirable, and SUS420J2 is the most desirable. In order to frictionally make contact with the elastic body 103, the contact body 104 is to be excellent in abrasion resistance. Thus, the surface of the contact body 104 is subjected to nitriding processing and/or alumite processing. Frictional force resulting from the pressure contact acts between the protrusions 106 and the contact body 104. The ends of the protrusions 106 are elliptically vibrated due to vibration generated by the electric-mechanical energy conversion element 120, thus generating driving force (thrust force) for driving the contact body 104. The contact body 104 is a member generally called "slider" or "rotor". In addition, "contact body" refers to a member that is brought into contact with the vibration body 110, and is movable relative to the vibration body 110 with vibrations generated by the vibration body 110. The contact of the contact body 104 with the vibration body 110 is not limited to direct contact where another member is not interposed therebetween. The contact of the contact body 104 with the vibration body 110 may be indirect contact where another member is interposed therebetween, as long as the contact body 104 is movable relative to the vibration body 110 with the vibrations generated by the vibration body 110. "Another member" is not limited to a member independent from the contact body 104 and the vibration body 110 (examples of such a member include a high-friction member of a sintered body). "Another member" may be a surface-processed part formed on the contact body 104 or the vibration body 110 through plating, nitriding, and/or the like.

<Vibration-Type Actuator using Ring-Shape Piezoelectric Material>

One region of the piezoelectric material 102 of the ring-shape piezoelectric element which is brought into contact with one driving phase electrode 101e is polarized in a polarity different from a polarity of the regions adjacent thereto. Thus, the stretching polarities in the regions of the piezoelectric material 102 are alternately inverted at a pitch of $\lambda/2$ when electric fields of the same polarity are applied to the driving phase electrodes 101e. When alternating voltage is applied to the first electrode 101a, a first standing wave having a wavelength $\lambda$ occurs across the entire circumference of the vibration body 110. Although a second standing wave similarly occurs with the application of the alternating voltage to the second electrode 101b, a position of the wave is rotationally moved by $\lambda/4$ in the circumferential direction with respect to the first standing wave. When two types of alternating voltage of the same frequency having a temporal phase difference $\pi/2$ are applied to the first and the second electrodes 101a and 101b, the following progressive wave occurs. A progressive wave (along the ring, having a wavenumber n and a wavelength $\lambda$) of bending vibration (i.e., vibrations with vibration amplitude perpendicular to the surface of the vibration body 110), traveling in the circumferential direction across the entire circumference in the vibration body 110 occurs as a result of composition of the first and the second standing waves.

When the progressive wave of bending vibration (hereinafter, simply referred to as "bending vibration wave") occurs, each point on the surface of a vibration plate of the vibration body 110 makes an elliptic motion, so that a moving body which is in contact with the surface is rotated by receiving the frictional force (driving force) in the circumferential direction from the vibration plate. The rotation direction thereof can be inverted by switching with a positive and a negative of a phase difference of the alternating voltages to be applied to the first and the second electrodes 101a and 101b. The rotation speed thereof is controllable with the frequency and the amplitude of the alternating voltages to be applied to the first and the second electrodes 101a and 101b.

Figs. 2A and 2B are diagrams illustrating two vibration modes of the vibration body 110 according to the present invention having a rectangular-shape piezoelectric material.

The first electrode 101a and the second electrode 101b are respectively arranged in a first region and a second region of the rectangular-shape piezoelectric material.

<Mode A>

When both of the first and the second regions are stretched or contracted, bending vibration of a first mode (mode A) occurs. In the mode A, a phase difference of alternating voltages VA and VB to be applied to the first electrode 101a and the second electrode 101b is 0°, and bending vibration is excited most intensively when the frequency is close to a resonant frequency of the mode A. The mode A is a primary out-of-plane vibration mode in which two nodes (points where vibration amplitude is minimized) appear substantially parallel to a long side of the vibration body 110. The two protrusions 106 of the elastic body 103 protruded in the same direction are arranged near the positions corresponding to anti-nodes (points where vibration amplitude is maximized) of the vibration in the mode A. Thus, an end surface of each of the protrusions 106 is reciprocally moved in a Z direction because of the vibration generated in the mode A.

<Mode B>

In response to the second region being contracted and stretched when the first region is stretched and contracted respectively, bending vibration of a second mode (mode B) occurs. In the mode B, a phase difference of the alternating voltages VA and VB to be applied to the first electrode 101a and the second electrode 101b is 180°, and bending vibration is excited most intensively when the frequency is close to the resonant frequency of the mode B. The mode B is a secondary out-of-plane vibration mode in which three nodes appear substantially parallel to a short side of the vibration body 110. The protrusions 106 of the elastic body 103 are arranged near the positions corresponding to the nodes of the vibration in the mode B. Thus, an end surface of each of the protrusions 106 is reciprocally moved in an X direction due to the vibration generated in the mode B.

The vibrations in the mode A and the mode B are excited at the same time when a phase difference of the alternating voltages VA and VB falls within the range of 0° to ±180°, and elliptical vibration is excited at the protrusions 106 of the elastic body 103 in the vibration-type actuator 100. It is desirable that the vibration-type actuator 100 that includes a rectangular-shape piezoelectric material and is driven by the vibrations of the modes A and B be used because a size thereof can easily be reduced.

In order to prevent hindering of vibrations caused by deformation of the pressurized foamed member 122, it is desirable that an area of a portion where the foamed member 122 is brought into contact with the electric-mechanical energy conversion element 120 be smaller than an area of a planar portion of the electric-mechanical energy conversion element 120 including that portion. It is possible to expect an effect of preventing the occurrence of a hindrance to vibration of a piezoelectric element, which is the electric-mechanical energy conversion element 120, due to the foamed member 122 being deformed and warping the side of the piezoelectric element and preventing the occurrence of a hindrance to vibration due to the foamed member interfering with peripheral members. It is also preferable that the foamed member 122 be smaller than the elastic body 103.

<Composition of Piezoelectric Material>

A composition of the piezoelectric material 102 is not specifically limited as long as the piezoelectric material 102 is a non-leaded piezoelectric material with a lead content of 1000 ppm or less. The lead content can be measured through, for example, the inductively coupled plasma (ICP) atomic emission spectroscopy.

It is desirable that a major component of the piezoelectric material 102 be barium titanate-based material.

It is desirable that the piezoelectric material 102 be made of a barium titanate-based material because the barium titanate-based material has a high piezoelectric constant and can be manufactured relatively easy. Herein, barium titanate ($BaTiO_3$), barium calcium titanate ($(Ba, Ca)TiO_3$), barium zirconate titanate ($Ba(Ti, Zr)O_3$) can be given as examples of the barium titanate-based material. Further, barium calcium zirconate titanate ($(Ba, Ca)(Ti, Zr)O_3$) can also be given as an example thereof. Furthermore, sodium niobate-barium titanate ($NaNbO_3$-$BaTiO_3$), bismuth sodium titanate-barium titanate, and bismuth kalium titanate-barium titanate can be given as the examples of a composition thereof. The barium titanate-based material refers to a material containing the above-described composition as a major component.

Further, a piezoelectric material that contains the above-described composition or a compound thereof as a major component can be used for the vibration-type actuator 100 of the present invention.

From among the above-described non-leaded piezoelectric materials, the barium titanate-based material is desirable for the piezoelectric material 102 of the electric-mechanical energy conversion element 120 according to the present embodiment. Barium calcium zirconate titanate is more desirable because the barium calcium zirconate titanate excels in temperature dependency of a piezoelectric property in the operating temperature range.

In particular, the following materials are desirable because both of the piezoelectric constant and the mechanical quality factor of the piezoelectric material 102 can be satisfied. In other words, it is desirable that the major component be barium calcium zirconate titanate ($(Ba, Ca)(Ti, Zr)O_3$) or sodium niobate-barium titanate ($NaNbO_3$-$BaTiO_3$). It is desirable that manganese (Mn) and/or bismuth (Bi) are/is contained as elements other than the major component. The major component refers to a material with a weight fraction of 10% or more.

It is desirable that the major component of the piezoelectric material 102 be the barium calcium zirconate titanate (hereinafter, called "BCTZ"). When the BCTZ is used as the major component, piezoelectricity of the BCTZ is adjustable by adjusting the amount of calcium (Ca) and zirconium (Zr) depending on use. Further, it is possible to reduce the use of niobium which is costly.

The above-described piezoelectric material 102 contains a perovskite-type oxide containing Ba, Ca, Ti, and Zr, and Mn, and it is desirable that a mole ratio x of Ca to a sum of Ba and Ca fall within a range of $0.02 \leq x \leq 0.30$, a mole ratio y of Zr to a sum of Ti and Zr fall within a range of $0.020 \leq y \leq 0.095$, $y \leq x$, a ratio $\alpha$ between a molar quantity of Ba and Ca and a molar quantity of Ti and Zr fall within a range of $0.9955 \leq \alpha \leq 1.01$, and an amount of Mn contained in 100 part-by-weight of oxide be 0.02 part-by-weight or greater and 1.0 part-by-weight or less in metal conversion.

Such a piezoelectric material can be expressed by the following general expression (1).

$$(Ba_{1-x}Ca_x)_\alpha(Ti_{1-y}Zr_y)O_3 \qquad (1)$$

Here, it is desirable that an amount of metallic components other than the major component in the piezoelectric material 102 with the perovskite-type metallic oxide expressed by the following expressions serving as a major component,

$$0.986 \leq \alpha \leq 1.100,$$

$$0.02 \leq x \leq 0.30,$$

$$0.02 \leq y \leq 0.095,$$

be 1 part-by-weight or less in metal conversion with respect to 100 part-by-weight of the metallic oxide.

In particular, it is desirable that Mn be contained in the metallic oxide, and that an amount of Mn contained in 100 part-by-weight of the metallic oxide be 0.02 part-by-weight or greater and 0.40 part-by-weight or less in metal conversion. The insulation property and a mechanical quality factor Qm are improved if Mn of the amount falling within the above-described range is contained. Herein, the mechanical quality factor Qm is a factor which represents an elastic loss caused by vibration when the piezoelectric material is evaluated as a vibration body, and a magnitude of the mechanical quality factor Qm is observed as sharpness of a resonant curve in impedance measurement. In other words, the mechanical quality factor Qm is a constant which represents the sharpness of resonance of the vibration body. When the mechanical quality factor Qm is large, a strain amount of the piezoelectric material 102 becomes greater near the resonance frequency, thus efficiently vibrating the piezoelectric material 102.

The metallic oxide expressed by the above general expression (1) means that Ba and Ca are metallic elements located in an A-site of the perovskite structure, and Ti and Zr are metallic elements located in a B-site thereof. However, Ba and Ca may partially be located in the B-site. Similarly, Ti and Zr may partially be located in the A-site.

The mole ratio of the elements located in the B-site to O elements is one to three (1:3) in the general expression (1). However, even if the mole ratio is slightly deviated, such a metallic oxide is included in the scope of the present invention as long as the metallic oxide has the perovskite structure as a main phase.

It is determinable whether the metallic oxide has the perovskite structure through a structural analysis based on, for example, an X-ray diffraction and an electron diffraction.

The mole ratio x of Ca located in the A-site expressed in the general expression (1) falls within the range of $0.02 \leq x \leq 0.30$. When Ba of the perovskite-type barium titanium is partially replaced with Ca within the above-described range, a phase transition temperature between orthorhombic and tetragonal structures is shifted to a low temperature side. Thus, stable piezoelectric vibrations can be obtained in a driving temperature range of the vibration-type actuator 100. However, for the mole ratio x greater than 0.30, the piezoelectric constant of the piezoelectric material 102 becomes insufficient. This may result in deficiency in performance of the vibration-type actuator 100. On the other hand, if the mole ratio x is less than 0.02, a dielectric loss (tan $\delta$) may increase. The increase of the dielectric loss may lead to an increase in an amount of heat generation when the vibration-type actuator 100 is being driven by applying voltage to the piezoelectric material 102, and driving efficiency of the motor is lowered. This may increase power consumption.

In the general expression (1), the mole ratio y of Zr in the B-site falls within the range of $0.02 \leq y \leq 0.1$. If the mole ratio y is greater than 0.1, a temperature Td becomes less than 80°C. Thus, a temperature range in which the vibration-type actuator 100 is usable becomes less than 80°C, which is not desirable.

In this specification, "Td" refers to a temperature that is the lowest from among the temperatures at which a piezoelectric constant of the piezoelectric material 102 that, after one week from the polarization processing, has been heated to Td from a room temperature and then has been cooled down to the room temperature again is dropped by 10% or more of a piezoelectric constant of the pre-heated piezoelectric material 102.

In the general expression (1), it is desirable that the ratio $\alpha$ between a molar quantity of Ba and Ca in the A-site and a molar quantity of Ti and Zr in the B-site fall within a range of $0.9955 \leq \alpha \leq 1.010$. In a case where the ratio $\alpha$ is less than 0.9955, abnormal grain growth is likely to occur in the crystalline grains forming the piezoelectric material 102, so that mechanical strength thereof is degraded. On the other hand, in a case where the ratio $\alpha$ is greater than 1.010, the piezoelectric material 102 is not densified, so that an insulation property thereof becomes significantly poor.

A method of measuring the composition of the piezoelectric material 102 is not particularly limited. Examples of methods for measuring the composition include X-ray fluorescence analysis, ICP atomic emission spectroscopy, and atomic absorption spectrometry. A weight ratio and a composition ratio of each element contained in the piezoelectric material 102 can be calculated by any one of the above-described measurement methods.

For the metal conversion indicating a contained amount of Mn, contained amounts of metals, namely, Ba, Ca, Ti, Zr, and Mn, measured from the piezoelectric material 102 with a method, such as fluorescent X-ray analysis (XRF), ICP atomic emission spectroscopy, or atomic absorption spectrometry, are each calculated. Further, oxide conversion values of the elements constituting the metal oxide expressed by the general expression (1) are calculated from the calculated contained amounts. Then, when a total weight thereof is set to 100, the contained amount of Mn in the metal conversion is represented as a ratio of a weight of Mn to the total weight.

With the contained amount of Mn less than 0.02 part-by-weight, an effect of polarization processing to drive the vibration-type actuator 100 may be insufficient. On the other hand, with the contained amount of Mn greater than 0.40 part-by-weight, a piezoelectric property of the piezoelectric material 102 may be unsatisfactory, and a crystal having a hexagonal crystalline structure which does not have a piezoelectric property may be developed. As long as Mn is contained in the piezoelectric material 102 as an Mn component, a form of contained Mn is not limited to a metal Mn. For example, Mn may be solid-soluted in the B-site, or may be included in a grain boundary. In view of an insulation property and sinterability, it is more desirable that Mn is contained in the B-site as a solid solution.

It is desirable that an amount of Bi contained in the piezoelectric material 102 be 0.042 part-by-weight or more and 0.850 part-by-weight or less in metal conversion.

The piezoelectric material 102 may contain Bi of 0.85 part-by-weight or less in metal conversion with respect to 100 part-by-weight of the metallic oxide expressed by the general expression (1). For example, an amount of Bi contained in the metallic oxide can be measured by ICP atomic emission spectroscopy. Bi may be present in a grain boundary of the ceramic-like piezoelectric material 102, or may be solid-soluted in the perovskite structure $(Ba, Ca)(Ti, Zr)O_3$. When Bi is present in the grain boundary, friction between particles decreases, and the mechanical quality factor increases. When Bi is incorporated into the solid solution which forms the perovskite structure, a phase transition temperature lowers, and temperature dependency of the piezoelectric constant decreases. Thus, the mechanical quality factor is further improved. It is desirable that Bi be incorporated into the solid solution in the A-site because a charge balance with the Mn is improved.

The piezoelectric material 102 may contain components (hereinafter, called "accessory components") other than the elements included in the general expression (1), Mn, and Bi, within a range where a property thereof is not fluctuated. It is desirable that a total of the accessory components be less than 1.2 part-by-weight with respect to 100 part-by-weight of the metallic oxide expressed by the general expression (1).

The piezoelectric property and an insulation property of the piezoelectric material 102 may be degraded with the accessory components greater than 1.2 part-by-weight.

It is further desirable that a phase transition temperature be -10°C or less because the piezoelectric material 102 excels in temperature dependency of the piezoelectric property in the operating temperature range (e.g., -30°C to 60°C) of the vibration-type actuator 100.

With a decrease in temperature from the room temperature, phase transition from a tetragonal system to an orthorhombic system sequentially occurs in the piezoelectric material 102 according to the present invention. A phase transition temperature in this specification indicates a temperature at which the phase transition occurs. To calculate the phase transition temperature, permittivity is measured while a temperature is being changed, and a temperature at which a value obtained by differentiating the permittivity with respect to sample temperatures is maximum is calculated as a phase transition temperature. A crystalline system can be evaluated through, for example, X-ray diffraction, electron diffraction, and Raman scattering. In vicinities of the phase transition temperature, the permittivity and the electromechanical coupling coefficient becomes maximum, whereas the Young's modulus becomes minimum. A piezoelectric constant is a function of these three parameters, and indicates a maximum value or an inflection point in the vicinities of the phase transition temperature.

An electronic device according to the present invention includes the vibration-type actuator 100 according to the present invention, members connected to the contact body 104 of the vibration-type actuator 100, and a member position detection unit (e.g., encoder). The electronic device can accurately control a position of a member by detecting the position of the member and operating the vibration-type actuator 100 until the member reaches a target position.

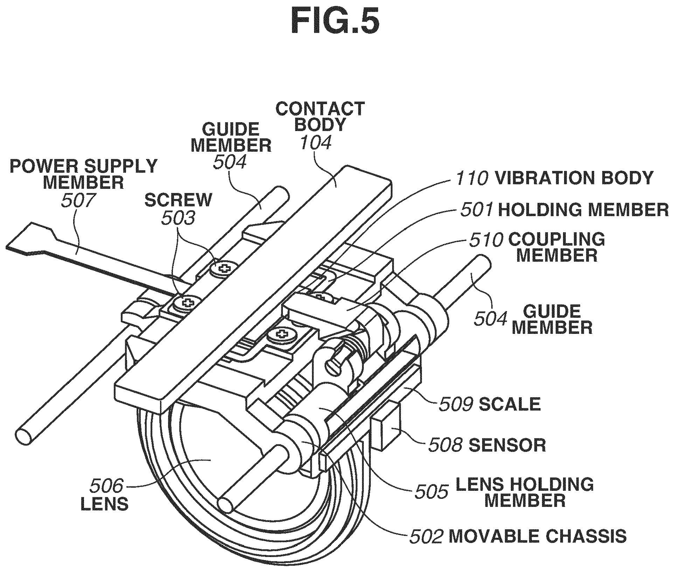

An optical device according to the present invention includes the electronic device according to the present invention and an optical element and/or an image sensor. Fig. 5 is a schematic diagram illustrating an embodiment of the optical device (i.e., a focus lens portion of a lens barrel apparatus) of the present invention. In Fig. 5, a vibration body 110 including a rectangular-shape piezoelectric material 102 is pressed against and brought into contact with a contact body (slider) 104 in a state similar to the state illustrated in Fig. 1D. A power supply member 507 is connected to the surface of the vibration body 110 including the first and the second regions. When desired voltage is applied to the vibration body 110 from a voltage input unit (not illustrated) via the power supply member 507, elliptic motion occurs at protrusions 106 of an elastic body 103 (not illustrated). A holding member 501 is connected to the vibration body 110 and prevents the occurrence of unnecessary vibration. A movable chassis 502 is fixed to the holding member 501 with screws 503, and is integrated with the vibration body 110. These members form the electronic device according to the present invention. The movable chassis 502 is attached to guide members 504, so that the electronic device of the present invention is rectilinearly movable in both directions (i.e., forward and reverse directions) along the guide members 504.

Next, a lens 506 (optical member) serving as a focus lens of a lens barrel apparatus will be described. The lens 506 is fixed to a lens holding member 505 and has an optical axis (not illustrated) parallel to a moving direction of the vibration-type actuator 100. The lens holding member 505 rectilinearly moves along the below-described two guide members 504 in a way similar to the vibration-type actuator 100 to perform focal position adjustment (focusing operation).

The two guide members 504 mesh the movable chassis 502 with the lens holding member 505 so that the movable chassis 502 and the lens holding member 505 are rectilinearly movable. Such a configuration enables the movable chassis 502 and the lens holding member 505 to be rectilinearly move along the guide members 504.

A coupling member 510 is meshed with and attached to the lens holding member 505, and transmits driving power generated by the vibration-type actuator 100 to the lens holding member 505. This configuration enables the lens holding member 505 to smoothly move in both directions along the two guide members 504 together with the movable chassis 502.

A sensor 508 reads positional information indicated by a scale 509 attached to a side of the lens holding member 505 to detect a position of the lens holding member 505 on the guide members 504. As described above, these members are assembled to form the focus lens portion of the lens barrel apparatus.

In the above, although a lens barrel apparatus used for a single-lens reflex camera has been described as the optical device, the present embodiment is applicable to various optical devices including the vibration-type actuators, such as a compact camera with a camera main body integrated with a lens and an electronic still camera, regardless of a type of camera.

As another configuration of the vibration-type actuator 100, a plurality of vibrators is brought into contact with a common contact body, so that the contact body is moved relative to the plurality of vibrators with vibrations generated by the plurality of vibrators.

As an application example of the vibration-type actuator 100 of the present embodiment, application to the medical field or the engineering field may be considered. More specifically, it is possible to provide a wire-drive actuator including an elongated member, a wire inserted into the elongated member and fixed to part of the elongated member, and the above-described vibration-type actuator 100 that drives the wire, and the elongated member is inflected by the wire being driven.

<Examples>

Next, the vibration-type actuator 100 and the vibration body 110 according to the present invention will be described with examples. However, the present invention is not limited to the following examples.

<Example 1>

A piezoelectric material 102 having a manufacturing composition 1 described in table 2 was obtained by firing of metal-oxide powder at 1340°C.

The manufacturing composition 1 is a composition expressed by the general expression (1), and values "x", "y", and "a" illustrated in table 2 correspond to the respective values in the above-described general expression (1).

After the obtained piezoelectric material 102 was uniformly ground and polished to a thickness of approximately 0.5 mm, the piezoelectric material 102 was formed into a ring shape having an outer diameter of 62 mm and an inner diameter of 54 mm. The driving phase electrode 101e and the non-driving phase electrodes 101f illustrated in Fig. 1C were formed on one side of the ring-shaped piezoelectric material 102. The electrodes 101e and 101f were formed of silver paste dried and baked after being applied to the piezoelectric material 102 through screen printing.

Next, an adhesive agent was applied to the elastic body 103 made of SUS420J2, and the elastic body 103 was pressed and bonded on the piezoelectric material 102 on which the electrodes 101e and 101f were formed. The ring-shape piezoelectric material 102 and the ring-shape elastic body 103 were arranged by using a positioning jig, so that respective centers of the ring shapes conformed to each other. Subsequently, thermal processing for hardening the adhesive agent was performed. The piezoelectric material 102 on which the elastic body 103 was pressed and bonded was heated to a temperature T1 (T1 = 160°C), was cooled down to a room temperature after being retained for 180 sec., and released from a pressed state, thus obtaining a vibration body 110. Next, a flexible printed circuit (FPC) on which anisotropic conductive paste (ACP) was applied was thermally pressed and bonded onto the electrodes 101e and 101f formed on the piezoelectric material 102. The thermal pressure bonding conditions are that a temperature T2 = 140°C and a retention time is 20 sec. Thereafter, the SUS420J2 serving as an elastic body was grounded, and polarization processing was performed by alternately applying voltages of different polarities to the driving phase electrodes 101e adjacent to each other. In the polarization processing, a plurality of external electrodes connected to a power source was brought into contact with an electrode to be used as a sensor from among the driving phase electrodes 101e and the non-driving phase electrodes 101f. The piezoelectric material 102 was then heated to a temperature T3, which is 100°C, and an electric field corresponding to 2 kV/mm was applied thereto for thirty minutes. Thereafter, the piezoelectric material 102 was cooled down to 40°C in forty minutes in a state where the electric field was being applied thereto. Then, the voltage application was ended. Thereafter, the vibration body was obtained by printing and drying the first and the second electrodes 101a and 101b. In order to prevent depolarization of the piezoelectric material 102, a temperature of the piezoelectric material 102 is maintained under 80°C in drying processing. The obtained vibration body 110 was pressed against and brought into contact with the contact body (rotor) made of SUS420J2, thus manufacturing the vibration-type actuator 100. A type of foamed member 122 with a siloxane bond serving as a main skeleton, arranged between the electric-mechanical energy conversion element 120 and the pressure member 121, is illustrated in the example 1 in table 1. The foamed member 122 contains silicon rubber, and a percentage of closed-cell bubbles accounting for the bubbles contained in the foamed member 122 was 50% or greater.

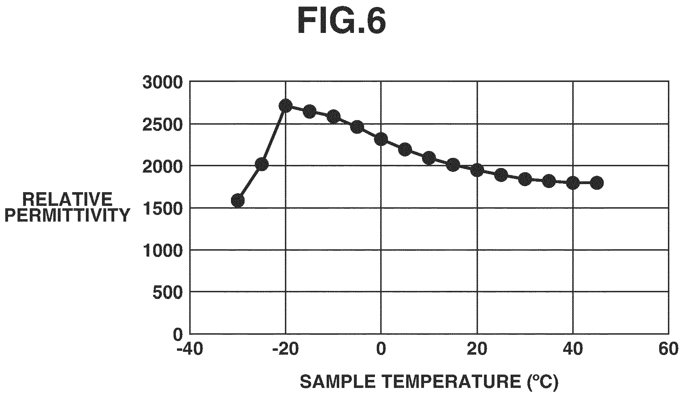

Further, a piezoelectric element used for evaluating the properties of the piezoelectric material 102 was created with the following method. The piezoelectric material 102 obtained through the firing was ground to a thickness of 0.5 mm, and gold electrodes having a thickness of 400 nm were formed on the front and back surfaces thereof through a direct-current (DC) sputtering method. A titanium film having a thickness of 30 nm, serving as an adhesion layer, was formed between the electrodes and ceramics. The ceramics with the electrodes were cut thus manufacturing a strip-like piezoelectric element having a size of 10 mm × 2.5 mm × 0.5 mm. Polarization processing was performed by applying an electric field of 1 kV/mm to the obtained piezoelectric element on a hot plate whose surface temperature was set to 60°C to 100°C. An electrostatic capacitance was measured and a relative permittivity was calculated by using an impedance analyzer 4194A manufactured by Agilent Technologies, Inc., while the sample temperature of the polarized piezoelectric element was being changed. The relative permittivity was measured while the sample was being cooled, and a temperature at which a value obtained by differentiating the relative permittivity with respect to a sample temperature is maximum was defined as a phase transition temperature at which a crystalline system is changed to an orthorhombic system from a tetragonal system. With respect to the piezoelectric material 102 described in the example 1, a value of the relative permittivity with respect to the sample temperature is illustrated in Fig. 6. The result illustrated in Fig. 6 indicates that a phase transition temperature for the piezoelectric material 102 described in the example 1 was -20°C.


<Example 2>


As in the example 1, a piezoelectric material 102 having the manufacturing composition 1 was obtained. After the obtained piezoelectric material 102 was substantially uniformly ground and polished to a thickness of 0.35 mm, the piezoelectric material 102 was formed into a rectangular shape having a size of 8.9 mm × 5.7 mm. The first and second electrodes illustrated in Fig. 1F were formed on both surfaces of the rectangular-shape piezoelectric material 102 with a method similar to the method used for the example 1.

Next, an adhesive agent was applied to the elastic body 103 made of SUS420J2, and the elastic body 103 was pressed and bonded onto the rectangular-shape piezoelectric material 102 on which the electrodes were formed. The elastic body 103 used in this example has a rectangular-shape portion of 9.1 mm × 5.8 mm, which is larger than the piezoelectric material 102, and a thickness thereof falls within the range of 0.25 mm to 0.30 mm. The rectangular-shape piezoelectric material 102 and the elastic body 103 were arranged by using a positioning jig so that centers of the rectangular shape portions thereof conformed to each other and sides of the rectangular-shape portions were parallel to each other. In a state where the piezoelectric material 102 was pressed and bonded, the piezoelectric material 102 was heated to a temperature T1 (T1 = 160°C), cooled down to a room temperature after being retained for 180 sec., and released from the pressed state, thus obtaining a vibration body 110.

Next, an FPC on which ACP was applied was pressed and bonded onto the piezoelectric material 102 for twenty seconds by using an iron heated to a temperature T2 (T2 = 140°C), so that the FPC was thermally pressed and bonded to the electrodes formed on the piezoelectric material 102.

Subsequently, polarization processing was performed on the piezoelectric material 102. In the polarization processing, the elastic body 103 was grounded, and external electrodes connected to a power source were each brought into contact with the first and the second electrodes. Although the first and the second electrodes were connected to the FPC, the electrodes was not entirely covered with the FPC, so that the external electrodes used for the polarization processing were contacted to the exposed portion. The piezoelectric material 102 was then heated to a temperature T3 (T3 = 100C), and an electric field equivalent to 2 kV/mm was applied for thirty minutes. Thereafter, forty minutes was spent on cooling down the piezoelectric material 102 to 40C in a state where the electric field was being applied thereto. the vibration body 110 obtained through these processes was pressed against and brought into contact with the contact body 104 (slider) made of SUS420J2, thus manufacturing the vibration-type actuator 100. The type of foamed member 122 with a siloxane bond serving as a main skeleton, arranged between the electric-mechanical energy conversion element 120 and the pressure member 121, is illustrated in the example 2 in table 1.

<Table 1>

| Drive Characteristics | | | | | |
|---|---|---|---|---|---|
| Change Rate to Comparison Example (%) | | | | | |
| 20°C | | -20°C | | -30°C | |
| Maximum Speed | Rated Power | Maximum Speed | Rated Power | Maximu m Speed | Rated Power |
| +20 | -10 | +20 | -20 | +40 | -30 |
| +20 | -10 | +20 | -20 | +40 | -30 |
| +20 | -8 | +20 | -18 | +35 | -25 |
| 0 | 0 | 0 | -10 | 0 | -10 |
| 0 | 0 | 0 | -10 | 0 | -10 |
| 0 | 0 | 0 | -10 | 0 | -10 |

| | Piezoelectric Material | Foamed Member | | | | | |
|---|---|---|---|---|---|---|---|
| | Shape | Type | Material | Average Equivalent Circle Diameter ($\mu$m) | Thickness (mm) | Skin Layer | Bubble Type |
| Example 1 | Ring Shape | Foamed Member A | Silicon Rubber | 324 | 2 | Absent | 50% or more Closed-Cell |
| Example 2 | Rectangular Shape | Foamed Member A | Silicon Rubber | 324 | 2 | Absent | 50% or more Closed-Cell |
| Example 3 | Rectangular Shape | Foamed Member B | Silicon Rubber | 439 | 2 | Absent | 50% or more Closed-Cell |
| Example 4 | Rectangular Shape | Foamed Member C | Silicon Rubber | 174 | 2 | Absent | 50% or more Closed-Cell |
| Example 5 | Rectangular Shape | Foamed Member D | Silicon Rubber | 202 | 2 | Present | 50% or more Closed-Cell |
| Eample 6 | Rectangular Shape | Foamed Member E | Silicon Rubber | 210 | 1 | Present | 50% or more Closed-Cell |

<Examples 3 to 6>

Vibration-type actuators 100 of the examples 3 to 6 were manufactured with a method similar to the method used for the example 2, except that types of foamed members 122 each having a siloxane bond serving as a main skeleton arranged between the electric-mechanical energy conversion element 120 and the pressure member 121 were used as illustrated in the table 1.

<Comparison Example 1>

A vibration-type actuator 100 was manufactured with a method similar to the method used for the example 1, except that felt was arranged between the electric-mechanical energy conversion element 120 and the pressure member 121.

<Comparison Example 2>

A vibration-type actuator 100 was manufactured with a method similar to the method used for the example 2, except that felt was arranged between the electric-mechanical energy conversion element 120 and the pressure member 121.

<Evaluation Method for Vibration-Type Actuator>

A driving experiment was conducted on each of vibration-type actuators 100 in the examples and the comparison examples by applying alternating voltage having an amplitude 130 Vpp to the first and the second electrodes. Phase differences of the voltage applied to the first and the second electrodes were -90° and 90°.

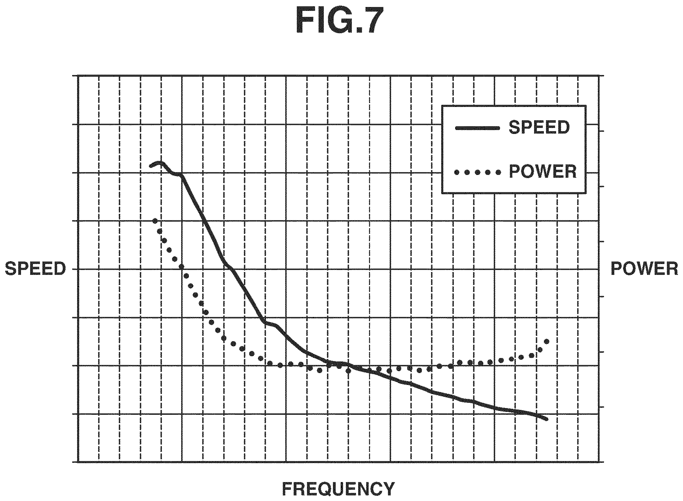

When a frequency of the alternating voltage is swept toward a resonance frequency from a frequency higher than resonance frequencies in the vibration mode A and the vibration mode B, the contact body 104 is driven in a direction according to the phase difference of the alternating voltage, and the contact body 104 stops after reaching a maximum speed. For descriptive purposes, traveling directions when the phase differences are -90° and 90° are called "reverse direction" and "forward direction", respectively. A maximum speed of the vibration body 110 and a frequency at which a speed of the vibration body 110 reached the maximum speed were measured by a sensor. Power (rated power) at a rated speed lower than the maximum speed was calculated from the electric current flowing in a driving circuit. Examples of measurement results of speed and power with respect to the frequency are illustrated in Fig. 7.

Further, in order to check the temperature stability, the maximum speed and the rated power were measured under the environmental atmosphere at 20°C, which is a room temperature condition, and under the environmental atmosphere at -20°C and -30°C, which is a low temperature condition. The average values for the reverse direction and the forward direction were then calculated.

At each of the temperatures, an amount of change in maximum speed and rated power of the vibration-type actuator 100 in the example 1 with respect to those of the vibration-type actuator 100 manufactured in the comparison example 1 were calculated. Similarly, an amount of change in maximum speed and rated power of the vibration-type actuator 100 in each of the examples 2 to 6 with respect to those of the vibration-type actuator 100 manufactured in the comparison example 2 were calculated. Acquired results are illustrated in the table 1.

In each of the examples 1 and 2 in which the foamed member A with a siloxane bond serving as a main skeleton is used, the maximum speed increased and the rated power lowered at each temperature with respect to each of the vibration-type actuators 100 of the comparison examples 1 and 2 using felt.

Further, in the example 3 using the foamed member B, an increase in the maximum speed and a decrease in the rated power were affirmed at each temperature.

In the environment of 20°C, no change was observed in each of the examples 4 to 6 respectively using the foamed members C, D, and E, with respect to the comparison example 2. In contrast, in the low-temperature environments of -20°C and -30°C, an effect of decreasing the rated power with respect to the comparison example 2 was affirmed.

<Example 7>

An optical device in Fig. 5 was manufactured by dynamically connecting the vibration-type actuator 100 manufactured in the example 2 with optical members. By controlling the alternating voltage applied to the piezoelectric material 102 based on the positional information provided to an encoder including a sensor and a scale, the vibration-type actuator 100 and the optical members connected to the vibration-type actuator 100 were accurately driven to a target position. It has been affirmed that an optical lens was connected to the vibration-type actuator 100 and that the optical device has an auto-focus function.

The above-described embodiment has been described by taking the manufacturing composition 1 as an example. However, as in the example 2, even in a case where the manufacturing compositions 2 to 86 were used, it was affirmed that the driving properties of the vibration-type actuator 100 of the present invention were improved as compared to the vibration-type actuator 100 using felt. In addition, phase transition temperatures of the piezoelectric materials 102 having the manufacturing compositions 2 to 4 were fall within the range of 5°C to -10°C, and a degree of improvement in driving properties was less than that of the piezoelectric material 102 having the manufacturing composition 1.

As described above, it was found that arranging a foamed member 122 with a siloxane bond serving as a main skeleton, whose average equivalent circle diameter of bubbles is greater than 120 $\mu$m, between the pressure member 121 and the vibration body 110 is desirable. Such a configuration makes it possible to provide a vibration-type actuator, using a non-leaded piezoelectric material, capable of preventing or reducing an increase in consumption power in driving the actuator 100 at low temperatures.

<Table 2>

| | x | y | a | Mn Concentration (Part by Weight) | Bi Concentration (Part by Weight) |
|---|---|---|---|---|---|
| Manufacturing Composition 1 | 0.140 | 0.080 | 0.9985 | 0.140 | 0.000 |
| Manufacturing Composition 2 | 0.020 | 0.020 | 1.002 | 0.10 | 0.00 |
| Manufacturing Composition 3 | 0.095 | 0.060 | 1.001 | 0.08 | 0.00 |
| Manufacturing Composition 4 | 0.125 | 0.090 | 1.000 | 0.06 | 0.00 |
| Manufacturing Composition 5 | 0.095 | 0.030 | 1.002 | 0.08 | 0.00 |
| Manufacturing Composition 6 | 0.095 | 0.095 | 0.999 | 0.24 | 0.85 |
| Manufacturing Composition 7 | 0.110 | 0.075 | 0.9994 | 0.240 | 0.170 |
| Manufacturing Composition 8 | 0.110 | 0.075 | 0.9994 | 0.240 | 0.170 |
| Manufacturing Composition 9 | 0.110 | 0.075 | 0.9994 | 0.240 | 0.340 |
| Manufacturing Composition 10 | 0.110 | 0.075 | 0.9969 | 0.240 | 0.510 |
| Manufacturing Composition 11 | 0.110 | 0.075 | 0.9994 | 0.040 | 0.550 |
| Manufacturing Composition 12 | 0.120 | 0.080 | 0.9994 | 0.240 | 0.170 |
| Manufacturing Composition 13 | 0.120 | 0.080 | 0.9994 | 0.240 | 0.340 |
| Manufacturing Composition 14 | 0.125 | 0.020 | 1.003 | 0.08 | 0.00 |
| Manufacturing Composition 15 | 0.125 | 0.050 | 1.001 | 0.06 | 0.00 |
| Manufacturing Composition 16 | 0.125 | 0.055 | 1.000 | 0.06 | 0.00 |
| Manufacturing Composition 17 | 0.130 | 0.075 | 0.9994 | 0.240 | 0.170 |
| Manufacturing Composition 18 | 0.140 | 0.075 | 1.003 | 0.02 | 0.00 |
| Manufacturing Composition 19 | 0.140 | 0.075 | 1.000 | 0.02 | 0.00 |
| Manufacturing Composition 20 | 0.140 | 0.075 | 1.003 | 0.07 | 0.00 |
| Manufacturing Composition 21 | 0.140 | 0.075 | 1.000 | 0.07 | 0.00 |
| Manufacturing Composition 22 | 0.140 | 0.075 | 1.001 | 0.08 | 0.00 |
| Manufacturing Composition 23 | 0.140 | 0.078 | 0.9955 | 0.160 | 0.181 |
| Manufacturing Composition 24 | 0.140 | 0.075 | 1.0004 | 0.160 | 0.094 |
| Manufacturing Composition 25 | 0.140 | 0.075 | 1.0004 | 0.160 | 0.094 |
| Manufacturing Composition 26 | 0.140 | 0.075 | 1.0004 | 0.160 | 0.094 |
| Manufacturing Composition 27 | 0.140 | 0.075 | 1.0004 | 0.160 | 0.094 |
| Manufacturing Composition 28 | 0.140 | 0.075 | 1.0004 | 0.160 | 0.094 |
| Manufacturing Composition 29 | 0.140 | 0.075 | 1.0004 | 0.160 | 0.189 |
| Manufacturing Composition 30 | 0.140 | 0.075 | 1.0004 | 0.160 | 0.239 |
| Manufacturing Composition 31 | 0.140 | 0.075 | 1.0004 | 0.160 | 0.189 |
| Manufacturing Composition 32 | 0.140 | 0.075 | 1.0004 | 0.160 | 0.189 |
| Manufacturing Composition 33 | 0.140 | 0.075 | 1.0004 | 0.160 | 0.189 |
| Manufacturing Composition 34 | 0.140 | 0.085 | 1.0004 | 0.160 | 0.539 |

(continued)

| | x | y | a | Mn Concentration (Part by Weight) | Bi Concentration (Part by Weight) |
|---|---|---|---|---|---|
| Manufacturing Composition 35 | 0.140 | 0.080 | 1.0004 | 0.140 | 0.189 |
| Manufacturing Composition 36 | 0.140 | 0.080 | 1.0004 | 0.140 | 0.289 |
| Manufacturing Composition 37 | 0.140 | 0.080 | 1.0004 | 0.140 | 0.339 |
| Manufacturing Composition 38 | 0.140 | 0.075 | 1.0004 | 0.160 | 0.094 |
| Manufacturing Composition 39 | 0.155 | 0.020 | 1.005 | 0.15 | 0.00 |
| Manufacturing Composition 40 | 0.155 | 0.035 | 1.006 | 0.18 | 0.00 |
| Manufacturing Composition 41 | 0.155 | 0.041 | 1.004 | 0.18 | 0.00 |
| Manufacturing Composition 42 | 0.155 | 0.065 | 1.000 | 0.02 | 0.00 |
| Manufacturing Composition 43 | 0.155 | 0.065 | 1.001 | 0.06 | 0.00 |
| Manufacturing Composition 44 | 0.155 | 0.065 | 1.004 | 0.06 | 0.00 |
| Manufacturing Composition 45 | 0.155 | 0.065 | 1.001 | 0.10 | 0.00 |
| Manufacturing Composition 46 | 0.155 | 0.065 | 1.005 | 0.10 | 0.00 |
| Manufacturing Composition 47 | 0.155 | 0.069 | 1.004 | 0.18 | 0.00 |
| Manufacturing Composition 48 | 0.155 | 0.078 | 0.9994 | 0.240 | 0.170 |
| Manufacturing Composition 49 | 0.160 | 0.059 | 1.009 | 0.40 | 0.00 |
| Manufacturing Composition 50 | 0.160 | 0.078 | 1.0042 | 0.360 | 0.170 |
| Manufacturing Composition 51 | 0.160 | 0.075 | 0.9971 | 0.180 | 0.170 |
| Manufacturing Composition 52 | 0.160 | 0.085 | 0.9971 | 0.180 | 0.170 |
| Manufacturing Composition 53 | 0.170 | 0.075 | 0.9971 | 0.180 | 0.170 |
| Manufacturing Composition 54 | 0.170 | 0.075 | 0.9998 | 0.140 | 0.189 |
| Manufacturing Composition 55 | 0.170 | 0.085 | 1.0010 | 0.120 | 0.189 |
| Manufacturing Composition 56 | 0.170 | 0.075 | 0.9971 | 0.180 | 0.170 |
| Manufacturing Composition 57 | 0.170 | 0.085 | 0.9971 | 0.180 | 0.170 |
| Manufacturing Composition 58 | 0.170 | 0.075 | 1.0042 | 0.360 | 0.170 |
| Manufacturing Composition 59 | 0.175 | 0.030 | 1.004 | 0.15 | 0.00 |
| Manufacturing Composition 60 | 0.175 | 0.055 | 1.004 | 0.06 | 0.00 |
| Manufacturing Composition 61 | 0.175 | 0.090 | 1.007 | 0.10 | 0.00 |
| Manufacturing Composition 62 | 0.187 | 0.060 | 1.001 | 0.12 | 0.00 |
| Manufacturing Composition 63 | 0.187 | 0.060 | 1.007 | 0.18 | 0.00 |
| Manufacturing Composition 64 | 0.187 | 0.060 | 1.003 | 0.18 | 0.00 |
| Manufacturing Composition 65 | 0.187 | 0.060 | 1.009 | 0.24 | 0.00 |
| Manufacturing Composition 66 | 0.187 | 0.060 | 1.003 | 0.24 | 0.00 |
| Manufacturing Composition 67 | 0.187 | 0.060 | 1.008 | 0.30 | 0.00 |
| Manufacturing Composition 68 | 0.187 | 0.060 | 1.010 | 0.40 | 0.00 |
| Manufacturing Composition 69 | 0.187 | 0.079 | 0.9994 | 0.240 | 0.170 |
| Manufacturing Composition 70 | 0.187 | 0.077 | 0.9994 | 0.240 | 0.170 |
| Manufacturing Composition 71 | 0.200 | 0.035 | 1.006 | 0.20 | 0.00 |
| Manufacturing Composition 72 | 0.200 | 0.055 | 1.005 | 0.22 | 0.00 |
| Manufacturing Composition 73 | 0.200 | 0.070 | 1.007 | 0.24 | 0.00 |

(continued)

|  | x | y | a | Mn Concentration (Part by Weight) | Bi Concentration (Part by Weight) |
|---|---|---|---|---|---|
| Manufacturing Composition 74 | 0.200 | 0.090 | 1.006 | 0.26 | 0.00 |
| Manufacturing Composition 75 | 0.200 | 0.075 | 0.9994 | 0.240 | 0.170 |
| Manufacturing Composition 76 | 0.220 | 0.082 | 0.9994 | 0.240 | 0.170 |
| Manufacturing Composition 77 | 0.220 | 0.030 | 1.005 | 0.22 | 0.00 |
| Manufacturing Composition 78 | 0.220 | 0.065 | 1.005 | 0.15 | 0.00 |
| Manufacturing Composition 79 | 0.220 | 0.065 | 1.002 | 0.15 | 0.00 |
| Manufacturing Composition 80 | 0.220 | 0.065 | 1.007 | 0.20 | 0.00 |
| Manufacturing Composition 81 | 0.220 | 0.065 | 1.006 | 0.20 | 0.00 |
| Manufacturing Composition 82 | 0.220 | 0.065 | 1.005 | 0.25 | 0.00 |
| Manufacturing Composition 83 | 0.220 | 0.080 | 1.006 | 0.28 | 0.00 |
| Manufacturing Composition 84 | 0.260 | 0.065 | 1.004 | 0.26 | 0.00 |
| Manufacturing Composition 85 | 0.260 | 0.070 | 1.005 | 0.28 | 0.00 |
| Manufacturing Composition 86 | 0.300 | 0.095 | 1.008 | 0.30 | 0.00 |

<Industrial Applicability>

The vibration-type actuator according to the present invention is useable for various purposes, for example, driving a lens and/or an image sensor arranged on an image capturing apparatus (optical device), rotationally driving a photosensitive drum included in a copying machine, and driving a stage. While a single vibration-type actuator has been described in this specification, a ring-shape contact body can rotationally be driven by a plurality of vibration-type actuators arranged annularly.

According to the present invention, a vibration isolation property can be maintained even in a low-temperature environment. Thus, driving efficiency in the vibration-type actuator including the non-leaded piezoelectric material in the low-temperature environment can be improved while maintaining the driving efficiency at room temperature. Therefore, it is possible to realize a stable operation in the operating temperature range (e.g., -30°C to 60°C).

**Claims**

**1.** A vibration-type actuator (100) comprising:

a vibration body (110) including an electric-mechanical energy conversion element (120) with a lead content of 1000 ppm or less, and an elastic body (103) having a plate portion (108) and protrusions (106) protruding in a direction intersecting with a main surface of the plate portion (108); and
a contact body (104) in contact with the protrusions (106),
wherein the vibration body (110) and the contact body (104) are relatively moved by vibration of the vibration body (110),
**characterized in that**
the vibration-type actuator (100) further comprises a pressure member (121) pressing the vibration body (110) against the contact body (104) and a foamed member (122) arranged between the pressure member (121) and the vibration body (110), and
**in that**
the foamed member (122) contains, as a main skeleton, a siloxane bond including silicon and oxygen, and an average equivalent circle diameter of bubbles contained in the foamed member (122) is greater than 120 $\mu$m.

**2.** The vibration-type actuator (100) according to claim 1, wherein a major component of the foamed member (122) is a polymer with a methyl group bonded to the main skeleton.

**3.** The vibration-type actuator (100) according to claim 1, wherein the foamed member (122) contains silicon rubber.

4. The vibration-type actuator (100) according to claim 1, wherein the plate portion (108) has a rectangular shape.

5. The vibration-type actuator (100) according to claim 4, wherein the protrusions (106) are two protrusions protruding in a same direction.

6. The vibration-type actuator (100) according to claim 1, wherein the plate portion (108) has a ring shape.

7. The vibration-type actuator (100) according to claim 1, wherein the average equivalent circle diameter of the bubbles is 200 $\mu$m or greater.

8. The vibration-type actuator (100) according to claim 1, wherein the foamed member (122) is smaller than the electric-mechanical energy conversion element (120).

9. The vibration-type actuator (100) according to claim 8, wherein an area of a portion where the foamed member (122) is in contact with the electric-mechanical energy conversion element (120) is smaller than an area of a planar portion of the electric-mechanical energy conversion element (120) including the portion.

10. The vibration-type actuator (100) according to claim 1, wherein the foamed member (122) is smaller than the elastic body (103).

11. The vibration-type actuator (100) according to claim 1, wherein a percentage of closed-cell bubbles accounting for bubbles contained in the foamed member (122) is 50% or greater.

12. The vibration-type actuator (100) according to claim 1, wherein the electric-mechanical energy conversion element (120) includes an electrode (101) and a piezoelectric material (102), and a major component of the piezoelectric material (102) is a barium titanate-based material.

13. The vibration-type actuator (100) according to claim 12, wherein a major component of the piezoelectric material (102) is barium calcium zirconate titanate.

14. The vibration-type actuator (100) according to claim 13, wherein a phase transition temperature of the piezoelectric material (102) is -10°C or less.

15. An electronic device comprising:

   a member (501); and
   the vibration-type actuator (100) according to claim 1 arranged on the member (501).

16. An optical device comprising:

   a member (501);
   at least one of an optical element (506) and an image sensor arranged on the member; and
   the vibration-type actuator (100) according to claim 1 arranged on the member.


**Patentansprüche**

1. Aktuator (100) vom Vibrationstyp, umfassend:

   einen Vibrationskörper (110), der umfasst: ein Element (120) zur elektro-mechanischen Energieumwandlung mit einem Bleigehalt von 1000 ppm oder weniger und einen elastischen Körper (103) mit einem Plattenabschnitt (108) und Vorsprüngen (106), die in einer Richtung vorstehen, die eine Hauptfläche des Plattenabschnitts (108) schneidet; und
   einen Kontaktkörper (104) in Kontakt mit den Vorsprüngen (106),
   wobei der Vibrationskörper (110) und der Kontaktkörper (104) durch Vibration des Vibrationskörpers (110) relativ zueinander bewegt werden,
   **dadurch gekennzeichnet, dass**
   der Aktuator (100) vom Vibrationstyp ferner umfasst: ein Druckelement (121), das den Vibrationskörper (110) gegen den Kontaktkörper (104) drückt, und ein geschäumtes Element (122), das zwischen dem Druckelement (121) und dem Vibrationskörper (110) angeordnet ist, und

dass das geschäumte Element (122) als ein Hauptgerüst eine Siloxanbindung enthält, die Silicium und Sauerstoff umfasst, und ein durchschnittlicher flächengleicher Kreisdurchmesser von Blasen, die in dem geschäumten Element (122) enthalten sind, größer als 120 μm ist.

2. Aktuator (100) vom Vibrationstyp nach Anspruch 1, wobei eine Hauptkomponente des geschäumten Elements (122) ein Polymer mit einer an das Hauptgerüst gebundenen Methylgruppe ist.

3. Aktuator (100) vom Vibrationstyp nach Anspruch 1, wobei das geschäumte Element (122) Silikonkautschuk enthält.

4. Aktuator (100) vom Vibrationstyp nach Anspruch 1, wobei der Plattenabschnitt (108) rechteckig ist.

5. Aktuator (100) vom Vibrationstyp nach Anspruch 4, wobei die Vorsprünge (106) zwei in einer gleichen Richtung vorstehende Vorsprünge sind.

6. Aktuator (100) vom Vibrationstyp nach Anspruch 1, wobei der Plattenabschnitt (108) ringförmig ist.

7. Aktuator (100) vom Vibrationstyp nach Anspruch 1, wobei der durchschnittliche flächengleiche Kreisdurchmesser der Blasen 200 μm oder mehr beträgt.

8. Aktuator (100) vom Vibrationstyp nach Anspruch 1, wobei das geschäumte Element (122) kleiner ist als das Element (120) zur elektro-mechanischen Energieumwandlung.

9. Aktuator (100) vom Vibrationstyp nach Anspruch 8, wobei eine Fläche eines Abschnitts, in dem das geschäumte Element (122) mit dem Element (120) zur elektro-mechanischen Energieumwandlung in Kontakt steht, kleiner ist als eine Fläche eines planaren Abschnitts des Elements (120) zur elektro-mechanischen Energieumwandlung, der den Abschnitt umfasst.

10. Aktuator (100) vom Vibrationstyp nach Anspruch 1, wobei das geschäumte Element (122) kleiner ist als der elastische Körper (103).

11. Aktuator (100) vom Vibrationstyp nach Anspruch 1, wobei ein Prozentsatz von geschlossenzelligen Blasen von in dem geschäumten Element (122) enthaltenen Blasen 50 % oder mehr beträgt.

12. Aktuator (100) vom Vibrationstyp nach Anspruch 1, wobei das Element (120) zur elektro-mechanischen Energieumwandlung eine Elektrode (101) und ein piezoelektrisches Material (102) umfasst und eine Hauptkomponente des piezoelektrischen Materials (102) ein Material auf Bariumtitanatbasis ist.

13. Aktuator (100) vom Vibrationstyp nach Anspruch 12, wobei eine Hauptkomponente des piezoelektrischen Materials (102) Barium-Calcium-Zirkonat-Titanat ist.

14. Aktuator (100) vom Vibrationstyp nach Anspruch 13, wobei eine Phasenübergangstemperatur des piezoelektrischen Materials (102) -10° C oder weniger beträgt.

15. Elektronische Vorrichtung, umfassend:

ein Element (501); und
den Aktuator (100) vom Vibrationstyp nach Anspruch 1, der auf dem Element (501) angeordnet ist.

16. Optische Vorrichtung, umfassend:

ein Element (501);
mindestens eines von einem optischen Element (506) und einem Bildsensor, die auf dem Element angeordnet sind; und
den Aktuator (100) vom Vibrationstyp nach Anspruch 1, der auf dem Element angeordnet ist.

**Revendications**

1. Actionneur de type à vibration (100) comprenant :

un corps de vibration (110) comportant un élément de conversion d'énergie électrique-mécanique (120) ayant une teneur en plomb de 1000 ppm ou moins, et un corps élastique (103) ayant une partie plaque (108) et des saillies (106) faisant saillie dans une direction faisant intersection avec une surface principale de la partie plaque (108) ; et
un corps de contact (104) en contact avec les saillies (106),
dans lequel le corps de vibration (110) et le corps de contact (104) sont déplacés l'un par rapport à l'autre par une vibration du corps de vibration (110),
**caractérisé en ce que**
l'actionneur de type à vibration (100) comprend en outre un organe de pression (121) pressant le corps de vibration (110) contre le corps de contact (104) et un organe alvéolaire (122) agencé entre l'organe de pression (121) et le corps de vibration (110) et
**en ce que**
l'organe alvéolaire (122) contient, en tant que squelette principal, une liaison siloxane comportant du silicium et de l'oxygène, et un diamètre de cercle équivalent moyen de bulles contenues dans l'organe alvéolaire (122) est supérieur à 120 $\mu$m.

2. Actionneur de type à vibration (100) selon la revendication 1, dans lequel un constituant majeur de l'organe alvéolaire (122) est un polymère ayant un groupe méthyle lié au squelette principal.

3. Actionneur de type à vibration (100) selon la revendication 1, dans lequel l'organe alvéolaire (122) contient du caoutchouc de silicone.

4. Actionneur de type à vibration (100) selon la revendication 1, dans lequel la partie plaque (108) possède une forme rectangulaire.

5. Actionneur de type à vibration (100) selon la revendication 4, dans lequel les saillies (106) sont deux saillies faisant saillie dans une même direction.

6. Actionneur de type à vibration (100) selon la revendication 1, dans lequel la partie plaque (108) possède une forme annulaire.

7. Actionneur de type à vibration (100) selon la revendication 1, dans lequel le diamètre de cercle équivalent moyen des bulles est de 200 $\mu$m ou plus.

8. Actionneur de type à vibration (100) selon la revendication 1, dans lequel l'organe alvéolaire (122) est plus petit que l'élément de conversion d'énergie électrique-mécanique (120).

9. Actionneur de type à vibration (100) selon la revendication 8, dans lequel une aire d'une partie où l'organe alvéolaire (122) est en contact avec l'élément de conversion d'énergie électrique-mécanique (120) est plus petite qu'une aire d'une partie plane de l'élément de conversion d'énergie électrique-mécanique (120) comportant la partie.

10. Actionneur de type à vibration (100) selon la revendication 1, dans lequel l'organe alvéolaire (122) est plus petit que le corps élastique (103).

11. Actionneur de type à vibration (100) selon la revendication 1, dans lequel un pourcentage de bulles à cellule fermée comptant pour des bulles contenues dans l'organe alvéolaire (122) est de 50 % ou plus.

12. Actionneur de type à vibration (100) selon la revendication 1, dans lequel l'élément de conversion d'énergie électrique-mécanique (120) comporte une électrode (101) et un matériau piézoélectrique (102), et un constituant majeur du matériau piézoélectrique (102) est un matériau à base de titanate de baryum.

13. Actionneur de type à vibration (100) selon la revendication 12, dans lequel un constituant majeur du matériau piézoélectrique (102) est le titanate-zirconate de baryum et de calcium.

**14.** Actionneur de type à vibration (100) selon la revendication 13, dans lequel une température de transition de phase du matériau piézoélectrique (102) est de -10 °C ou moins.

**15.** Dispositif électronique comprenant :

un organe (501) ; et
l'actionneur de type à vibration (100) selon la revendication 1 agencé sur l'organe (501).

**16.** Dispositif optique comprenant :

un organe (501) ;
au moins l'un parmi un élément optique (506) et un capteur d'image agencé sur l'organe ; et
l'actionneur de type à vibration (100) selon la revendication 1 agencé sur l'organe.

**FIG.1A**

104
108
100 { 120
122
103
121

**FIG.1D**

104
100
103
121
120

**FIG.1B**

106
103
110 {
102

**FIG.1E**

103
110
106
102

**FIG.1C**

102    101f
101b
101a
101f    101e

**FIG.1F**

102
107
108
101a    101b
101

# FIG.2A

MODE A

# FIG.2B

MODE B

# FIG.3

133

EP 4 280 853 B1

FIG.4A

FIG.4B

133

133

134

# FIG.5

POWER SUPPLY MEMBER 507

GUIDE MEMBER 504

SCREW 503

CONTACT BODY 104

110 VIBRATION BODY

501 HOLDING MEMBER

510 COUPLING MEMBER

504 GUIDE MEMBER

509 SCALE

508 SENSOR

505 LENS HOLDING MEMBER

502 MOVABLE CHASSIS

506 LENS

# FIG.6

# FIG.7

SPEED

POWER

FREQUENCY

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018107437 A
- JP 3289371 A
- EP 3716645 A1
- EP 2523231 A1
- EP 3579258 A1